# EUROPEAN PATENT APPLICATION

(11) **EP 2 685 490 A1**
(43) Date of publication of application: **15.01.2014**
(21) Application number: 13174926.9
(22) Date of filing: 03.07.2013
(51) Int. Cl.: H01L 21/67, H01L 21/673, B01J 3/00

(54) **Portable vacuum case with a sight-glass**

(30) Priority: 12.07.2012 PL 39992112
(71) Applicant: Instytut Chemii Fizycznej Polskiej Akademii Nauk, 01-224 Warszawa (PL); PREVAC Sp. z o.o., 44-362 Rogow (PL)
(72) Inventor: Sobczak, Janusz, 02-777 Warszawa (PL); Jablonski, Aleksander, 02-793 Warszawa (PL); Kutner, W odzimierz, 04-690 Warszawa (PL); Noworyta, Krzysztof, 05-804 Warszawa (PL); Glenz, Andreas, 44-362 Rogów (PL)
(74) Representative: Sielewiesiuk, Jakub

(57) **Abstract**

The object of the invention is a portable vacuum case, comprising a mobile vacuum chamber and a first valve as a closure assembly, characterised in that in the enclosure of the vacuum chamber (1), a sight-glass (2) or/and sight-glasses (3) are located.

## Description

It is an object of the invention to provide a portable vacuum case intended for carrying and for testing of samples under vacuum conditions.

From the offers of PREVAC, ULVAC-PHI or TECTRA companies, we know portable vacuum cases comprising a mobile vacuum chamber equipped with a valve, a closure assembly and an adjoined pumping chamber with a suitably arranged valve. This set allows to pump air out of the vacuum chamber. The vacuum chamber is used to store an object of interest under vacuum. Vacuum conditions may be required in their processing or characterisation of e.g. semiconductor wafers or other substrates. On the other hand, a lock serves as the pumping chamber when inserting or moving an object to or from the mobile vacuum chamber.

Similar solutions are known from US patent application No. US 2006 102237 A1 and from US patent No. US 6168364 B1, as well as from international patent application No. WO 2004 001817 A1. Devices presented in those documents include vacuum chambers and elements for maintaining vacuum, such as closures, valves or pumps. In addition, each of these devices may include a conveying unit used for placing a sample inside the vacuum chamber.

Portable vacuum cases are used for convenient carrying of samples or objects (e.g. semiconductor wafers or other substrates) under vacuum conditions between devices designed for their processing or testing. In a typical application, the case is connected through the lock with the device (it may be a device for processing or characterisation of the sample - e.g. a spectrometer, a microscope or a processing chamber, etc.), the air is pumped out from the lock and the sample, intended for processing or testing, is carried between the vacuum chamber of the case and the said device (according to the needs). After testing or processing, the sample - in an analogous procedure - is once again placed in the vacuum case, so that it can be carried to another place.

To submit the sample to testing in the vacuum device (e.g. in the infrared reflection spectrophotometer), using vacuum cases known in the art, it is necessary to move the sample from the case to the measuring device and, having performed the measurements, to move the sample back to the case.

None of the known vacuum cases allows for performing the tests without moving the samples placed inside to the device intended for their processing or testing.

It is therefore an object of the present invention to design and to construct a portable vacuum case with sight-glasses, specially adapted to both easy carrying and testing of samples located inside the vacuum chamber of this case without the need to remove and to place these samples in another location.

According to the invention, a portable vacuum case, comprising a mobile vacuum chamber and a first valve as a closure assembly, is **characterised in that** in the enclosure of the vacuum chamber, a sight-glass or/and sight-glasses are located.

Preferably, the sight-glass or/and sight-glasses are arranged at an angle enabling the measurement of radiation reflected from the surface of the tested sample. These angles can also be dedicated to other measurement techniques.

Preferably, the sight-glasses are made of a material permeable to infrared radiation and visible light, e.g. of KBr. These sight-glasses can be made also of other materials in the case of other measurement techniques, e.g. CuBe, Al.

Preferably, the vacuum chamber is equipped with a station intercepting a sample carrier for moving the sample from or to the vacuum chamber.

Preferably, the case according to the invention can be connected with a pumping chamber or with a lock through an appropriate mounting-connecting set and gas can be pumped out of the case through a second valve.

Preferably, the case according to the invention is designed for connection to a mobile vacuum pump powered by an electric socket of a car, or by other power source.

Preferably, an ion pump, powered from an electrical outlet of 230 V AC voltage or of 12 V or 24 V DC voltage, is connected to the vacuum chamber of the case according to the invention.

Preferably, the vacuum chamber has one sight-glass or two sight-glasses disposed opposite to each other in a manner allowing the radiation beam to pass through the vacuum chamber.

Thanks to the vacuum case with sight-glasses according to the invention, there is no need to move the sample from the vacuum chamber of the case to the spectrophotometer or to other measuring device, because thanks to sight-glasses/windows, measurements can be performed on a sample remaining inside the vacuum chamber of the case. The radiation beam used to test the sample falls on the sample through the sight-glass/window. In the case of testing the reflected radiation - a beam reflected from the sample comes out through the same inlet sight-glass or through the second, outlet sight-glass and can be analysed. The second sight-glass is located on the opposite side of the portable vacuum chamber relative to the first sight-glass. In the case of testing the radiation passing through - a beam comes in through the inlet sight-glass, passes through the sample, and then comes out through the outlet sight-glass and can be analysed. The sight-glasses - both inlet and outlet ones - may also be used in such a way that the inlet sight-glass works as the outlet one, and the outlet one works as the inlet one.

### Preferred Embodiment of the Invention

The invention is further presented in the preferred embodiment of the mobile vacuum chamber, known as the vacuum case, designed for tests in connection with the infrared spectrometer, as presented in the accompanying drawing, in which:

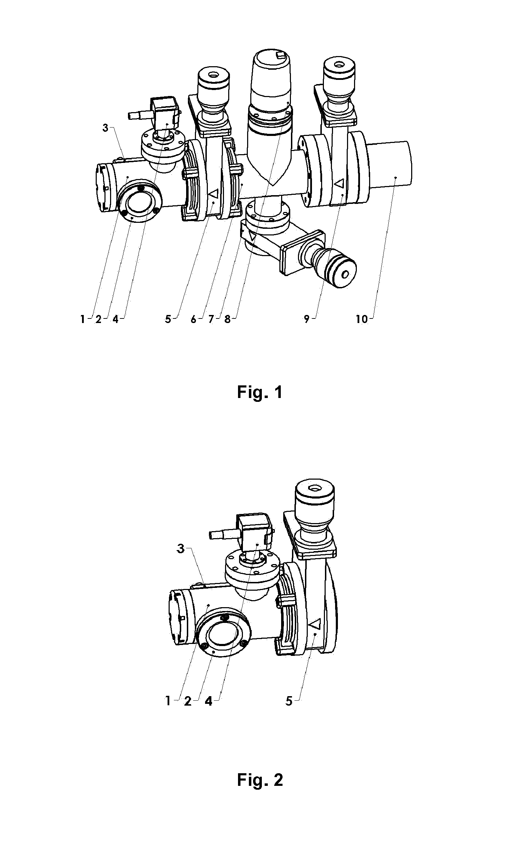

Fig. 1 presents the invention in an isometric view in conjunction with the rest of the processing-measuring system (of the analytical/processing vacuum system),
Fig. 2 presents the invention in an isometric view with the vacuum case alone,

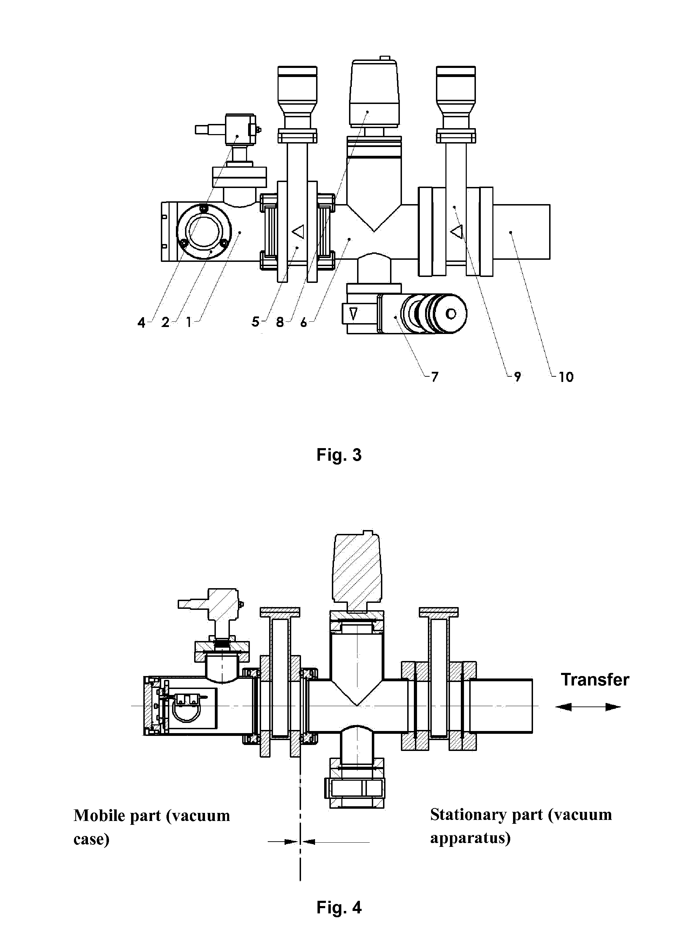

Fig. 3 presents the invention in a side view,
Fig. 4 presents the invention in a sectional side view,
Fig. 5 presents the invention in a top view,
Fig. 6 presents the vacuum case alone according to the invention, shown in Fig. 1-5, connected to the infrared spectrophotometer, the said case being mounted on a dedicated holder; a) - a top view, b) - a perspective view, and
Fig. 7 presents infrared spectra, registered in a reflection-absorption mode at an incidence angleof the radiation beam of 87°, of a thin layer of a molecularly non-imprinted polymer (curve 1), of a molecularly imprinted polymer with adrenaline (curve 2), of a polymer imprinted after extraction of adrenaline template with 0.1 M CH₃COOH (curve 3), and of a polymer imprinted after extraction of adrenaline template with 0.01 M NaOH (curve 4). The spectra were registered using vacuum case with sight glasses according to the invention.

In the drawings 1-6, the following designation was used: 1 - a mobile vacuum chamber, 2 - an inlet sight-glass, 3 - an outlet sight-glass, 4 - a mobile pump, 5 - a first valve coupled to the vacuum case, 6 - a pumping chamber or a lock, 7 - a second valve cutting off a pumping or locking system, 8 - a vacuum head, 9 - a third valve cutting off a transfer chamber, 10 - transfer of sample carriers from and to a vacuum apparatus, SP - IR spectrophotometer.

### Example 1

In this embodiment, the portable vacuum case with sight-glasses has all the necessary elements for measurements using infrared spectrophotometer.

Vacuum case in this particular embodiment is made in a cylindrical form, of a stainless steel, with a diameter of 63mm. It can also be made as a rectangular or square element, of other materials, e.g. of aluminium, titanium, etc., depending on the required magnetic fields or physicochemical resistance. Dimensions may vary, depending on the size of substrates and apparatus conditions. Seals in the specific case are made of elastomers, and of copper seals of CF type. Here, they can also be made in a different way using other materials. In this particular case a commercial valve was used, though an integrated and dedicated valve may be used, which will optimise the function of this device. Depending on the seals used and on the capabilities of pumping out, vacuums in full range of high vacuum (HV) and of ultrahigh vacuum (UHV) may be obtained.

### Example 2

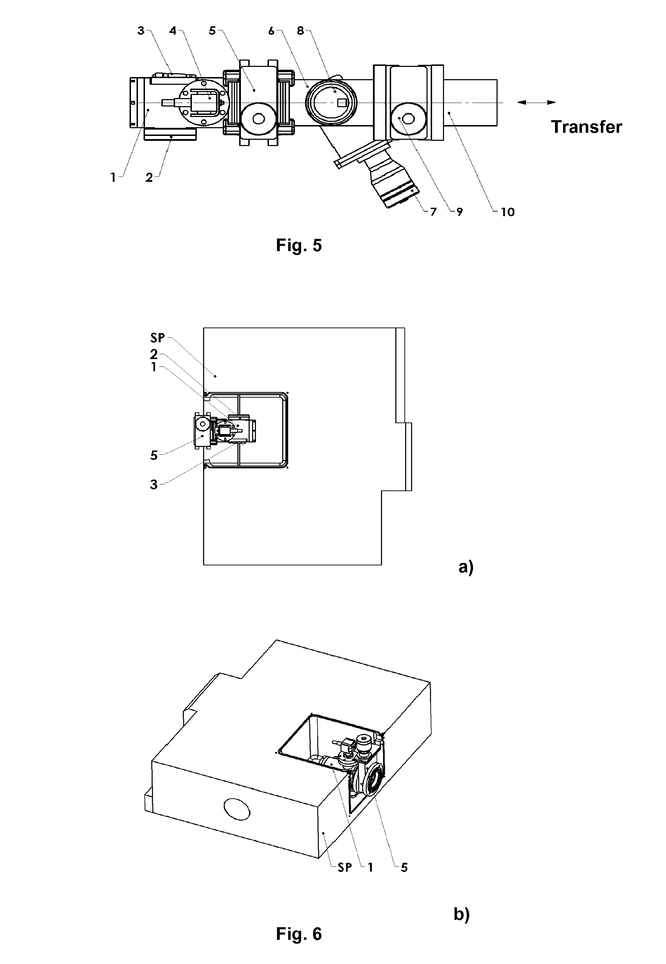

In this example, uses of the portable vacuum case with sight-glasses for measuring absorbance of polymer layers molecularly imprinted by means of infrared reflection-absorption spectroscopy (IRRAS) were presented. For this purpose, thin (about 300 nm) layers of polymer imprinted with adrenaline by electrochemical polymerisation on a glass plate covered with a layer of gold, according to the method described in the Polish patent application No. P-398219 dated Feb. 24th, 2012, were prepared. Two of the prepared samples were subjected to extraction, one with 0.01 M NaOH, and the other with 0.1 M CH₃COOH. For comparison, a layer of non-imprinted polymer was prepared in the same way. So deposited thin layers of these polymers were tested by X-ray photoelectron spectroscopy (XPS) under high vacuum to determine the extraction efficiency of adrenaline. Then, these samples were mounted in the holder inside the portable vacuum case with sight-glasses according to the invention in such a way that the sample surface was placed in the optical axis of the inlet sight-glass. In order to perform these measurements, in the case, sight-glasses of potassium bromide, ensuring high light transmittance in the infrared range, were mounted. Then, the case together with the sample was mounted in a dedicated holder of the measuring chamber of PMA50 module (Bruker Optics, Germany), as schematically shown in Fig. 6. Orientation of the case in the holder of the measuring chamber may be different from that shown in Fig. 6. In particular, it can be vertical or horizontal orientation, according to the design of the case and of the handle. The PMA50 module was attached to the spectrophotometer Vertex80v from Bruker Optics, controlled by OPUS 6.5 software from the same company. So mounted vacuum case was rotated around its main axis in such a way that the incidence angle of IR beam, of polarisation p, on the sample was 87°. The case was then fixed in this position. The IR radiation beam, reflected on the sample, came out through the outlet sight-glass and landed in liquid nitrogen-cooled MCT (mercury cadmium telluride) detector of the PMA50 module.

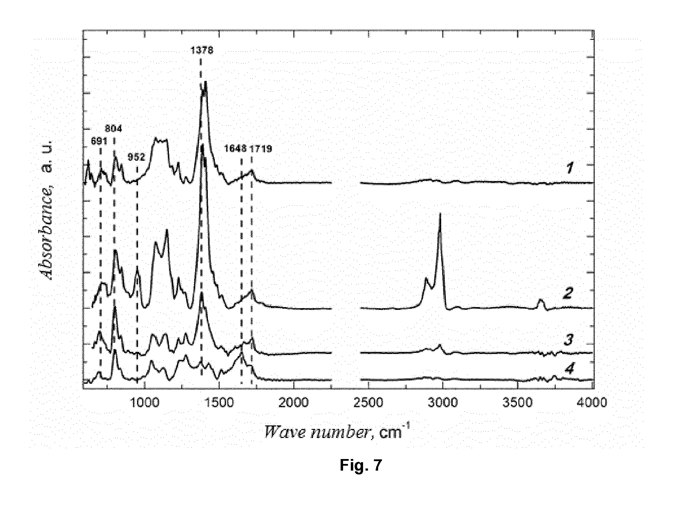

In the so prepared measuring system, first, IRRAS spectrum of gilded glass plate without a polymer layer was recorded, which served as a reference spectrum. Then, a spectrum of polymer molecularly imprinted with adrenaline before extraction, after extraction of adrenaline by means of 0.1 M CH₃COOH, after extraction of adrenaline by means of 0.01 M NaOH and of non-imprinted polymer were recorded (curve 2, 3, 4 and 1, respectively in Fig. 7). All spectra were recorded in the range of wave numbers from 4000 to 600 cm⁻¹. Spectra of the polymers, after background subtraction, are shown in Fig. 7. Peaks at 804 and 691 cm⁻¹, corresponding to deformation vibrations of C-S-C bonds and to stretching vibrations of C-S bonds, characteristic for thiophene polymers, are clearly visible in the spectra. In the spectra, one can distinguish also peaks at 1383 cm⁻¹ characteristic for CH₂ vibrations in the crown ether of one of the functional monomers and bands between 1640 and 1720 cm⁻¹ corresponding to -C=O vibrations in the carboxyl group present in the second one of the functional monomers. These results confirm the presence of both functional monomers in all the deposited polymer layers. According to the results of quantum mechanical calculations, the presence of peak at 952 cm⁻¹ in the spectrum of the polymer imprinted with adrenaline can be attributed to the complex vibrations of the adrenaline-crown ether system. The presence of this peak confirms the presence of adrenaline in the layer of imprinted polymer. Importantly, the peak is visible neither in the spectrum of the imprinted polymer layer, nor in the spectra of polymer layers after adrenaline extraction. This result also demonstrates the exhaustive removal of adrenaline from the polymer layer as a result of each of the two extraction procedures. Interestingly, during the adrenaline extraction by means of 0.01 M NaOH7), the peak characteristic for the COOH group vibrations, which in the polymer spectrum before extraction occurs at 1719 cm⁻¹ (curve 2 in Fig. 7), is shifted to 1648 cm⁻¹ in the polymer spectrum after extraction (curve 4 in Fig. 7). The peak at a higher wave number is characteristic for protonated carboxyl group, COOH, and the peak at a lower wave number - for deprotonated group, COO⁻. Therefore this shift indicates deprotonation of the carboxyl group in the polymer during the extraction of adrenaline using a strong base.

The above tests have demonstrated the usefulness of the vacuum case with sight-glasses according to the invention for recording infrared spectra of thin layers of polymers.

### Acknowledgments

Measurements checking the functioning of the vacuum case were funded with the European Regional Development Fund under the "Innovative Economy" project (Grant No. ERDF, POIG.01.01.02-00-008/08 2007-2013).

Costs relating to the protection of the invention were cofinanced by the "NanOtechnology, Biomaterials and aLternative Energy Source for ERA integration FP7-REGPOT-CT-2011-285949-NOBLESSE" project.

## Claims

1. A portable vacuum case, comprising a mobile vacuum chamber and a first valve as a closure assembly, **characterised in that** in the enclosure of the vacuum chamber (1), a sight-glass (2) or/and sight-glasses (3) are located.

2. The case according to claim 1, **characterised in that** the sight-glass (2) or/and sight-glasses (3) are arranged at an angle enabling the measurement of radiation reflected from the surface of the tested sample.

3. The case according to claim 1 or 2, **characterised in that** the sight-glasses (2) and (3) are made of materials permeable to infrared radiation and visible light, preferably of KBr or CuBE or Al.

4. The case according to any one of the preceding claims, **characterised in that** the vacuum chamber (1) is equipped with a station intercepting a sample carrier for moving the sample from or to the vacuum chamber (1).

5. The case according to any one of the preceding claims, **characterised in that** it can be connected to a pumping chamber or to the lock (6) and gas can be pumped out of it through a second valve (7).

6. The case according to any one of the preceding claims, **characterised in that** is designed for connection to a mobile vacuum pump powered by an electric socket of a car, or by other power source.

7. The case according to any one of the preceding claims, **characterised in that** an ion pump, powered from an electrical outlet of 230 V of alternating voltage or of 12 V or 24 V of direct voltage, is connected to the vacuum chamber.

8. The case according to any one of the preceding claims, **characterised in that** the vacuum chamber (1) has one sight-glass (2) or two sight-glasses (2, 3) disposed opposite to each other in a manner allowing the radiation beam to pass through the vacuum chamber (1).
